# EUROPEAN PATENT APPLICATION

(11) **EP 1 715 381 A1**
(43) Date of publication of application: **25.10.2006**
(21) Application number: 05709869.1
(22) Date of filing: 08.02.2005
(51) Int. Cl.: G03F 7/004, C08G 59/32, G03F 7/027

(54) **PHOTOSENSITIVE RESIN COMPOSITION AND CURED PRODUCT THEREOF**

(30) Priority: 09.02.2004 JP 2004031953
(71) Applicant: NIPPON KAYAKU KABUSHIKI KAISHA, Tokyo 102-8172 (JP)
(72) Inventor: TANAKA, Ryutaro, 1150042 (JP); NAKANISHI, Masataka, Saitama-shi, Saitama 330-0835 (JP); AKATSUKA, Yasumasa, Saitama-shi, Saitama 336-0964 (JP); KOYANAGI, Hiroo, 1750092 (JP)
(74) Representative: Behnisch, Werner
(86) International application number: PCT/JP2005/001817
(87) International publication number: WO 2005/076079

(57) **Abstract**

Disclosed is a photosensitive resin composition with excellent photosensitivity whose cured product is excellent in adhesiveness, pencil hardness, solvent resistance, acid resistance, heat resistance, gold plating resistance and the like. Also disclosed is such a cured product. Specifically disclosed is a photosensitive resin composition containing a resin (A) soluble in an aqueous alkaline solution, a crosslinking agent (B), a photopolymerization initiator (C) and a curing agent (D) wherein the curing agent (D) is an epoxy compound obtained by glycidylating a compound containing not less than 80% of a tetraphenylethane derivative represented by the following formula (1). 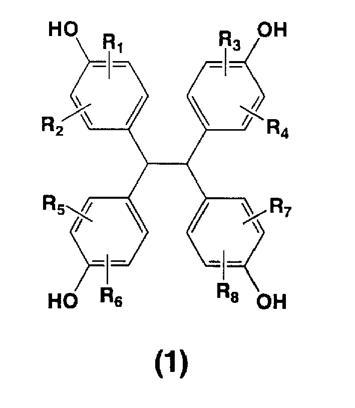 [In the formula, R₁ to R₈ independently represents a hydrogen atom, a C₁-C₄ alkyl group or a halogen atom.]

## Description

### Technical Field

The present invention relates to a photosensitive resin composition containing, as a curing agent, a compound obtained by glycidylating a tetraphenylethane derivative, and a cured product thereof. More particularly, the invention relates to a liquid or dry-film type resin composition which is useful as solder resists for printed wiring boards, interlayer insulating materials for multilayer printed wiring boards, solder resists for flexible printed wiring boards, dry-film resists, plating resists, materials for photosensitive optical waveguides, and the like and which can give cured products excellent in developability, heat resistance, thermal stability, electrical insulation properties, adhesiveness, chemical resistance, plating resistance, and the like, and a cured product thereof.

### Background Art

Photosensitive resin compositions containing photosensitive epoxy carboxylate compounds are excellent in balance between various properties, such as environmental, thermal, physical properties, and adhesiveness to substrates, and thus have been used in the fields of paint and coating, adhesives, and the like from a long time ago. Recently, the photosensitive resin compositions have been used widely in the industrial applications, such as manufacturing of electrical and electronic components, and manufacturing of printed boards, and the range of application thereof has been increasing. Furthermore, as the application field has expanded, there have been demands for addition of higher functions, such as heat resistance and adhesiveness, to photosensitive resin compositions containing epoxy carboxylate compounds, and development of various photosensitive resin compositions has been in progress mainly in the applications, such as manufacturing of electrical and electronic components, and manufacturing of printed boards.

With respect to printed wiring boards, in view of decreases in size and weight of mobile devices and improvement in communication speed, high accuracy and high density have been demanded. Accordingly, the levels of requirements for solder resists have been increasing, and there have been requirements for higher properties than before, that is, requirements for adhesiveness to substrate, high insulation properties, and resistance to electroless gold plating while maintaining higher heat resistance and thermal stability. However, in currently commercially available solder resists, these requirements are not satisfactorily met. For example, Patent Document 1 describes a solder mask composition containing a photosensitive resin obtained by adding an acid anhydride to a reaction product between a novolak epoxy resin and an unsaturated monobasic acid, a photopolymerization initiator, a crosslinking agent, and an epoxy resin. However, in the cured product of this composition, it is not possible to obtain satisfactory heat resistance, adhesiveness, and plating resistance. Furthermore, Patent Document 2 describes a photopolymerizable resin composition containing a urethane-modified vinyl ester resin. However, in the cured product of this composition, although flexibility is obtained, it is not possible to obtain satisfactory heat resistance and adhesiveness. Patent Documents 3, 4, and 5 each describes a high-purity compound obtained by glycidylating a tetraphenylethane derivative, as a substance, and a synthesis method thereof, but do not describe a photosensitive resin composition. Patent Documents 6 and 7 each describe a compound obtained by glycidylating a tetraphenylethane derivative as an example of a curing agent for photosensitive resin compositions. However, the compound used has low purity, and in the photosensitive resin composition, it is not possible to obtain satisfactory photosensitivity, developability, thermal stability, resolution, and heat resistance.
Patent Document 1: Japanese Unexamined Patent Application Publication No. 61-243869
Patent Document 2: Japanese Unexamined Patent Application Publication No. 9-52925
Patent Document 3: Japanese Patent No. 3573530
Patent Document 4: Japanese Unexamined Patent Application Publication No. 9-3162
Patent Document 5: Japanese Unexamined Patent Application Publication No. 2004-10877
Patent Document 6: Japanese Unexamined Patent Application Publication No. 10-20493
Patent Document 7: Japanese Unexamined Patent Application Publication No. 2004-12810

### Disclosure of Invention

### Problems to be Solved by the Invention

With respect to printed wiring boards, in view of decreases in size and weight of mobile devices and improvement in communication speed, high accuracy and high density have been demanded. Accordingly, the levels of requirements for solder masks have been increasing, and there have been demands for higher properties than before, that is, higher adhesiveness, resistance to soldering heat, and electroless gold plating resistance. However, in currently commercially available solder masks, these demands are not satisfactorily met. It is an object of the present invention to provide a resin composition which has excellent photosensitivity to an activated energy ray, which allows a fine image suitable for higher functions of today's printed wiring boards to be formed, which enables pattern formation by means of development using a dilute aqueous alkaline solution, which is capable of producing a cured film having satisfactory heat resistance, the cured film being obtained by heat curing in a post-cure step, and which is suitable for solder resist ink having high insulation properties, excellent adhesiveness, and excellent electroless gold plating resistance; and a cured product thereof.

### Means for Solving the Problems

The present inventors have conducted intensive research to solve the problems described above, and as a result, the present invention has been completed.

That is, the present invention relates to:
1) a photosensitive resin composition containing a resin (A) soluble in an aqueous alkaline solution, a crosslinking agent (B), a photopolymerization initiator (C), and a curing agent (D), wherein the curing agent (D) is an epoxy compound obtained by glycidylating a compound containing not less than 80% of a tetraphenylethane derivative represented by formula (1): 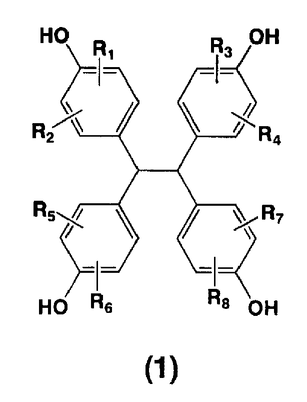 [wherein R₁ to R₈ each independently represents a hydrogen atom, a C₁ to C₄ alkyl group, or a halogen atom] ;
2) the photosensitive resin composition according to item 1), wherein the epoxy compound, which is the curing agent (D), is a compound obtained by glycidylating a tetraphenylethane derivative represented by formula (1), wherein each R₁ to R₈ is a hydrogen atom, and the compound has an epoxy equivalent of 120 to 200 g/equivalent;
3) the photosensitive resin composition according to item 1), wherein the epoxy compound, which is the curing agent (D), includes a compound represented by formula (2): 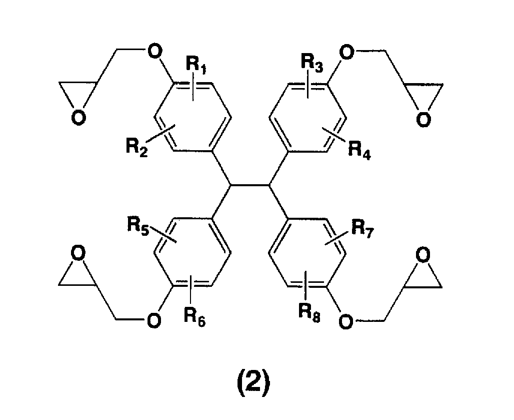 [wherein R₁ to R₈ each independently represents a hydrogen atom, a C₁ to C₄ alkyl group, or a halogen atom] and the content of the compound in the curing agent (D) is not less than 60 mole percent;
4) the photosensitive resin composition according to any one of items 1) to 3), wherein the curing agent (D) has a softening point or melting point of not less than 80°C;
5) the photosensitive resin composition according to any one of items 1) to 3), wherein the curing agent (D) has a light transmittance at 400 nm of not less than 10% in a 1 weight percent methyl ethyl ketone solution;
6) the photosensitive resin composition according to any one of items 1) to 5), wherein the resin (A) soluble in the aqueous alkaline solution is a reaction product between an epoxy carboxylate compound obtained by reaction of an epoxy compound (a) having two or more epoxy groups per molecule with a monocarboxylic acid (b) having an ethylenic unsaturated group per molecule, and a polybasic acid anhydride (c);
7) the photosensitive resin composition according to any one of items 1) to 5), wherein the resin (A) soluble in the aqueous alkaline solution is a reaction product between an epoxy carboxylate compound obtained by reaction of an epoxy compound (d) having two epoxy groups per molecule with a monocarboxylic acid (b) having an ethylenic unsaturated group per molecule, a diisocyanate compound (e), a carboxylic acid (f) having two hydroxyl groups per molecule, and, as an optional component, a diol compound (g);
8) a cured product of the photosensitive resin composition according to any one of items 1) to 7);
9) a substrate including a layer composed of the cured product according to item 8); and
10) an article including the substrate according to item 9) .

### Advantages

The photosensitive resin composition of the present invention is excellent in tackiness, exhibits excellent photosensitivity in the formation of a cured product obtained by exposing the photosensitive resin composition to an activated energy ray, such as ultraviolet light, enables pattern formation by means of development using a dilute aqueous alkaline solution, gives a cured product having satisfactory adhesiveness, pencil hardness, solvent resistance, acid resistance, heat resistance, gold plating resistance, insulation properties, PCT resistance, thermal shock resistance, and the like, the cured product being obtained by heat curing in a post-cure step, and is particularly suitable for solder resists for printed wiring boards. The photosensitive resin composition is also suitable for use in forming optical waveguides.

### Best Mode for Carrying Out the Invention

A photosensitive resin composition of the present invention contains a resin (A) soluble in an aqueous alkaline solution, a crosslinking agent (B), a photopolymerization initiator (C), and a curing agent (D), wherein the curing agent (D) is an epoxy compound obtained by glycidylating a compound containing not less than 80% of a tetraphenylethane derivative represented by the formula (1) described above [wherein R₁ to R₈ each independently represents a hydrogen atom, a C₁ to C₄ alkyl group, or a halogen atom].

The resin (A) soluble in the aqueous alkaline solution, which is contained in the photosensitive resin composition of the present invention, is not particularly limited as long as it is soluble in an aqueous alkaline solution. In particular, the resin (A) soluble in the aqueous alkaline solution is preferably a reaction product between an epoxy carboxylate compound obtained by reaction of an epoxy compound (a) having two or more epoxy groups per molecule with a monocarboxylic acid (b) having an ethylenic unsaturated group per molecule, and a polybasic acid anhydride (c), or a reaction product between an epoxy carboxylate compound obtained by reaction of an epoxy compound (d) having two epoxy groups per molecule with a monocarboxylic acid (b) having an ethylenic unsaturated group per molecule, a diisocyanate compound (e), a carboxylic acid (f) having two hydroxyl groups per molecule, and, as an optional component, a diol compound (g).

As the epoxy compound (a) having two or more epoxy groups per molecule, in particular, an epoxy compound having an epoxy equivalent of 100 to 900 g/equivalent is preferable. If the epoxy equivalent is less than 100 g/equivalent, in some cases, the molecular weight of the resulting resin (A) soluble in the aqueous alkaline solution may be small, resulting in difficulty in forming a film, or sufficient flexibility may not be obtained. If the epoxy equivalent exceeds 900 g/equivalent, in the reaction with the monocarboxylic acid (b) having the ethylenic unsaturated group, there may be a possibility that its introduction ratio decreases, resulting in a decrease in photosensitivity.

Specific examples of the epoxy compound (a) having two or more epoxy groups per molecule include a phenol novolak epoxy resin, a cresol novolak epoxy resin, a tris(hydroxyphenyl)methane epoxy resin, a dicyclo-pentadiene phenol-type epoxy resin, a bisphenol-A epoxy resin, a bisphenol-F epoxy resin, a biphenol-type epoxy resin, a bisphenol-A novolak epoxy resin, a naphthalene-skeleton-containing epoxy resin, an alicyclic epoxy resin, and a heterocyclic epoxy resin.

Examples of the phenol novolak epoxy resin include EPICLON N-770 (manufactured by Dainippon Ink and Chemicals, Inc.), D. E. N438 (manufactured by Dow Chemical Company), EPIKOTE 154 (manufactured by Yuka Shell Epoxy Co., Ltd.), and EPPN-201 and RE-306 (which are manufactured by Nippon Kayaku Co., Ltd).

Examples of the cresol novolak epoxy resin include EPICLON N-695 (manufactured by Dainippon Ink and Chemicals, Inc.), EOCN-102S, EOCN-103S, and EOCN-104S (all of which are manufactured by Nippon Kayaku Co., Ltd.), UVR-6650 (manufactured by Union Carbide Corporation), and ESCN-195 (manufactured by Sumitomo Chemical Co., Ltd).

Examples of the tris(hydroxyphenyl)methane epoxy resin include EPPN-503, EPPN-502H, and EPPN-501H (all of which are manufactured by Nippon Kayaku Co., Ltd.), TACTIX-742 (manufactured by Dow Chemical Company), and EPIKOTE E1032H60 (manufactured by Yuka Shell Epoxy Co., Ltd).

Examples of the dicyclo-pentadiene phenol-type epoxy resin include EPICLON EXA-7200 (manufactured by Dainippon Ink and Chemicals, Inc.) and TACTIX-556 (manufactured by Dow Chemical Company).

Examples of the bisphenol-type epoxy resin include bisphenol-A epoxy resins, such as EPIKOTE 828 and EPIKOTE 1001 (which are manufactured by Yuka Shell Epoxy Co., Ltd.), UVR-6410 (manufactured by Union Carbide Corporation), D. E. R-331 (manufactured by Dow Chemical Company), and YD-8125 (manufactured by Tohto Kasei Co., Ltd.), and bisphenol-F epoxy resins, such as UVR-6490 (manufactured by Union Carbide Corporation) and YDF-8170 (manufactured by Tohto Kasei Co., Ltd).

Examples of the biphenol-type epoxy resin include biphenol epoxy resins, such as NC-3000 and NC-3000-H (which are manufactured by Nippon Kayaku Co., Ltd.), bixylenol epoxy resins, such as YX-4000 (manufactured by Yuka Shell Epoxy Co., Ltd.), and YL-6121 (manufactured by Yuka Shell Epoxy Co., Ltd).

Examples of the bisphenol-A novolak epoxy resin include EPICLON N-880 (manufactured by Dainippon Ink and Chemicals, Inc.) and EPIKOTE E157S75 (manufactured by Yuka Shell Epoxy Co., Ltd).

Examples of the naphthalene-skeleton-containing epoxy resin include NC-7000 (manufactured by Nippon Kayaku Co., Ltd.) and EXA-4750 manufactured by Dainippon Ink and Chemicals, Inc).

Examples of the alicyclic epoxy resin include EHPE-3150 (manufactured by Daicel Chemical Industries, Ltd).

Examples of the heterocyclic epoxy resin include TEPIC (manufactured by Nissan Chemical Industries, Ltd).

Examples of the monocarboxylic acid (b) having the ethylenic unsaturated group per molecule include acrylic acids, crotonic acid, α-cyanocinnamic acid, cinnamic acid, and a reaction product between a saturated or unsaturated dibasic acid and an unsaturated group-containing monoglycidyl compound. Examples of acrylic acids include (meth)acrylic acid, β-styrylacrylic acid, β-furfurylacrylic acid, a half ester obtained by reaction between equimolar amounts of a saturated or unsaturated dibasic acid anhydride and a (meth)acrylate derivative having one hydroxyl group per molecule, a half ester obtained by reaction between equimolar amounts of a saturated or unsaturated dibasic acid and a monoglycidyl (meth)acrylate derivative, and a reaction product between (meth)acrylic acid and ε-caprolactone. In view of sensitivity of the resulting photosensitive resin composition, (meth)acrylic acid, a reaction product between (meth)acrylic acid and ε-caprolactone, or cinnamic acid is particularly preferable.

As the polybasic acid anhydride (c), any compound having at least one acid anhydride structure per molecule can be used. Examples thereof include succinic anhydride, acetic anhydride, phthalic anhydride, pyromellitic anhydride, maleic anhydride, tetrahydrophthalic anhydride, hexahydrophthalic anhydride, ethylene glycol bis(anhydrotrimellitate), glycerol-bis(anhydrotrimellitate) monoacetate, 1,2,3,4-butanetetracarboxylic dianhydride, 3,3',4,4'-diphenylsulfonetetracarboxylic dianhydride, 3,3',4,4'-benzophenonetetracarboxylic dianhydride, 3,3',4,4'-biphenyltetracarboxylic dianhydride, 3,3',4,4'-diphenylethertetracarboxylic dianhydride, 2,2-bis(3,4-anhydrodicarboxyphenyl)propane, 2,2-bis(3,4-anhydrodicarboxyphenyl)hexafluoropropane, 5-(2,5-dioxotetrahydro-3-furanyl)-3-methylcyclohexene-1,2-dicarboxylic anhydride, and 3a,4,5,9b-tetrahydro-5-(tetrahydro-2,5-dioxo-3-furanyl)-naphtho[1,2-c]furan-1,3-dione.

The preferable reaction product as the resin (A) soluble in the aqueous alkaline solution is obtained by subjecting an alcoholic hydroxyl group-containing epoxy carboxylate compound produced by reaction (hereinafter referred to as a "first reaction") of an epoxy compound (a) having two or more epoxy groups per molecule with a monocarboxylic acid (b) having an ethylenic unsaturated group per molecule to reaction (hereinafter referred to as a "second reaction") with a polybasic acid anhydride (c).

The first reaction can be carried out in the absence of a solvent or in a solvent that does not contain an alcoholic hydroxyl group. Examples the solvent include ketones, such as acetone, ethyl methyl ketone, and cyclohexanone; aromatic hydrocarbons, such as benzene, toluene, xylene, and tetramethylbenzene; glycol ethers, such as ethylene glycol dimethyl ether, ethylene glycol diethyl ether, dipropylene glycol dimethyl ether, dipropylene glycol diethyl ether, triethylene glycol dimethyl ether, and triethylene glycol diethyl ether; esters, such as ethyl acetate, butyl acetate, methyl cellosolve acetate, ethyl cellosolve acetate, butyl cellosolve acetate, carbitol acetate, propylene glycol monomethyl ether acetate, dialkyl glutarates (e.g., dimethyl glutarate), dialkyl succinates (e.g., dimethyl succinate), and dialkyl adipates (e.g., dimethyl adipate); cyclic esters, such as γ-butyrolactone; petroleum solvents, such as petroleum ether, petroleum naphtha, hydrogenated petroleum naphtha, and solvent naphtha; and the crosslinking agent (B) which will be described below. These organic solvents may be used alone or in combination of two or more.

With respect to the feed ratio of the starting materials in this reaction, preferably, the amount of the monocarboxylic acid (b) having the ethylenic unsaturated group per molecule is 80 to 120 equivalent percent relative to one equivalent of the epoxy compound (a). If the amount deviates from the range described above, there is a possibility that gelation may occur during the second reaction or the resulting resin (A) soluble in the aqueous alkaline solution may have decreased thermal stability.

During the reaction, preferably, a catalyst is used to accelerate the reaction. When the catalyst is used, the amount of use thereof is 0.1% to 10% by weight relative to the reactants. In such a case, the reaction temperature is 60°C to 150°C, and the reaction time is preferably 5 to 60 hours. Specific examples of the catalyst that may be used include triethylamine, benzyldimethylamine, triethylammonium chloride, benzyltrimethylammonium bromide, benzyltrimethylammonium iodide, triphenylphosphine, triphenylstibine, methyltriphenylstibine, chromium octanoate, and zirconium octanoate.

Furthermore, preferably, as a thermal polymerization inhibitor, hydroquinone monomethyl ether, 2-methylhydroquinone, hydroquinone, diphenylpicrylhydrazine, diphenylamine, 2,6-di-tert-butyl-p-cresol, or the like is used.

While performing sampling in an appropriate manner, the first reaction is terminated at a point where the acid value of the sample is 1 mg·KOH/g or less, and preferably 0.5 mg·KOH/g or less.

In the present invention, the acid value of solid content is defined as an amount (mg) of potassium hydroxide required for neutralizing the acidity of carboxylic acid in 1 g of a resin, and the acid value is defined as an amount (mg) of potassium hydroxide required for neutralizing 1 g of a solution including a resin. The acid value is determined by ordinary neutralization titration according to JIS K0070. Furthermore, if the concentration of a resin in a solution is known, it is also possible to calculate the acid value of solid content from the acid value of the solution.

The second reaction is an esterification reaction in which, after the termination of the first reaction, a polybasic acid anhydride (c) is allowed to react with the reaction liquid. The second reaction can be carried out in the absence of a catalyst. Alternatively, in order to accelerate the reaction, a basic catalyst can be used. When the catalyst is used, the amount of use thereof is 10% by weight or less relative to the reactants. In such a case, the reaction temperature is 40°C to 120°C, and the reaction time is preferably 5 to 60 hours.

With respect to the feed ratio of the polybasic acid anhydride (c), preferably, the amount of addition is calculated so that the acid value of solid content of the resin (A) soluble in the aqueous alkaline solution is 50 to 150 mg·KOH/g. If the acid value of solid content is less than 50 mg·KOH/g, solubility to the alkaline solution becomes insufficient, and there is a possibility that residue may occur when patterning is performed, or in the worst case, it may not be possible to perform patterning. If the acid value of solid content exceeds 150 mg·KOH/g, solubility to the alkaline solution becomes excessively high, and there is a possibility that the photo-cured pattern may be detached, thus being undesirable.

Although the epoxy compound (d) having two epoxy groups per molecule used in the reaction to obtain a preferable reaction product as the resin (A) soluble in the aqueous alkaline solution is not particularly limited, an epoxy compound having an epoxy equivalent of 100 to 900 g/equivalent is preferable. If the epoxy equivalent is less than 100 g/equivalent, in some cases, the molecular weight of the resulting resin (A) soluble in the aqueous alkaline solution may be small, resulting in difficulty in forming a film, or sufficient flexibility may not be obtained. If the epoxy equivalent exceeds 900 g/equivalent, in the reaction with the monocarboxylic acid (b) having the ethylenic unsaturated group, there may be a possibility that its introduction ratio decreases, resulting in a decrease in photosensitivity.

In the present invention, the term "epoxy equivalent" is used in the same meaning as in the ordinary use. The epoxy equivalent corresponds to the mass of an epoxy compound containing 1 g equivalent of epoxy group, is represented in unit of g/equivalent, and is determined by a method according to JIS K 7236, or the like.

Specific examples of the epoxy compound (d) having two epoxy groups per molecule include phenyl diglycidyl ethers, such as hydroquinone diglycidyl ether, catechol diglycidyl ether, and resorcinol diglycidyl ether; bisphenol-type epoxy compounds, such as bisphenol-A epoxy resins, bisphenol-F epoxy resins, bisphenol-S epoxy resins, and epoxy compounds of 2,2-bis(4-hydroxyphenyl)-1,1,1,3,3,3-hexafluoropropane; hydrogenated bisphenol-type epoxy compounds, such as hydrogenated bisphenol-A epoxy resins, hydrogenated bisphenol-F epoxy resins, hydrogenated bisphenol-S epoxy resins, and epoxy compounds of hydrogenated 2,2-bis(4-hydroxyphenyl)-1,1,1,3,3,3-hexafluoropropane; halogenated bisphenol-type epoxy compounds, such as brominated bisphenol-A epoxy resins and bisphenol-S epoxy resins; alicyclic diglycidyl ether compounds, such as cyclohexanemethanol diglycidyl ether compounds; aliphatic diglycidyl ether compounds, such as 1,6-hexanediol diglycidyl ether, 1,4-butanediol diglycidyl ether, and diethylene glycol diglycidyl ether; polysulfide-type diglycidyl ether compounds, such as polysulfide diglycidyl ether; and biphenol-type epoxy resins.

With respect to these epoxy compounds, examples of the commercially available products include bisphenol-A epoxy resins, such as EPIKOTE 828, EPIKOTE 1001, EPIKOTE 1002, EPIKOTE 1003, and EPIKOTE 1004 (all of which are manufactured by Japan Epoxy Resin Co., Ltd.), EPOMIC R-140, EPOMIC R-301, and EPOMIC R-304 (all of which are manufactured by Mitsui Chemicals, Inc.), DER-331, DER-332, and DER-324 (all of which are manufactured by Dow Chemical Company), EPICLON 840 and EPICLON 850 (which are manufactured by Dainippon Ink and Chemicals, Inc.), UVR-6410 (manufactured by Union Carbide Corporation), RE-310S (manufactured by Nippon Kayaku Co., Ltd.), and YD-8125 (manufactured by Tohto Kasei Co., Ltd.); bisphenol-F epoxy resins, such as UVR-6490 (manufactured by Union Carbide Corporation), YDF-2001, YDF-2004, and YDF-8170 (all of which are manufactured by Tohto Kasei Co., Ltd.), and EPICLON 830 and EPICLON 835 (which are manufactured by Dainippon Ink and Chemicals, Inc.); hydrogenated bisphenol-A epoxy resins, such as HBPA-DGE (manufactured by Maruzen Petrochemical Co., Ltd.) and Rika Resin HBE-100 (manufactured by Shin-Nihon Kagaku Kogyo Co., Ltd.); brominated bisphenol-A epoxy resins, such as DER-513, DER-514, and DER-542 (all of which are manufactured by Dow Chemical Company); alicyclic epoxy resins, such as Celoxide 2021 (manufactured by Daicel Chemical Industries, Ltd.), Rika Resin DME-100 (manufactured by Shin-Nihon Kagaku Kogyo Co., Ltd.), and EX-216 (manufactured by Nagase Chemical Co., Ltd.); aliphatic diglycidyl ether compounds, such as ED-503 (manufactured by ADEKA Corp.), Rika Resin W-100 (manufactured by New Japan Chemical Co., Ltd.), and EX-212, EX-214, and EX-850 (all of which are manufactured by Nagase Chemical Co., Ltd.); polysulfide-type diglycidyl ether compounds, such as FLEP-50 and FELP-60 (which are manufactured by Toray Thiokol Co., Ltd.); and biphenol-type epoxy resins, such as YX-4000 (manufactured by Japan Epoxy Resin Co., Ltd).

The diisocyanate compound (e) is not particularly limited as long as the compound has two isocyanato groups per molecule, and also a plurality of diisocyanate compounds may be used. In particular, in view of flexibility and the like, specific examples of the preferred diisocyanate compound (e) include phenylene diisocyanate, tolylene diisocyanate, xylylene diisocyanate, tetramethylxylylene diisocyanate, diphenylmethane diisocyanate, naphthalene diisocyanate, tolidine diisocyanate, hexamethylene diisocyanate, dicyclohexylmethane diisocyanate, isophorone diisocyanate, arylene sulfone ether diisocyanate, allylcyan diisocyanate, N-acyl diisocyanate, trimethylhexamethylene diisocyanate, 1,3-bis(isocyanatomethyl)cyclohexane, and methyl norbornene-diisocyanate.

As the carboxylic acid (f) having two hydroxyl groups per molecule, any diol compound having an alcoholic hydroxyl group or a phenolic hydroxyl group and a carboxyl group per molecule can be used, and in particular, an alcoholic hydroxyl group which has excellent developability in an aqueous alkaline solution is preferable. Examples thereof include dimethylolpropionic acid and dimethylolbutanoic acid.

The diol compound (g) as the optional component is not particularly limited as long as it is an aliphatic or alicyclic compound in which two hydroxyl groups are bonded to two different carbon atoms. Examples thereof include ethylene glycol, propylene glycol, trimethylene glycol, 1,4-butanediol, 1,5-pentanediol, 1,6-hexanediol, 1,7-heptanediol, 1,8-octanediol, 1,9-nonanediol, 1,10-decanediol, hydrobenzoin, benzpinacol, cyclopentane-1,2-diol, cyclohexane-1,2-diol, cyclohexane-1,4-diol, cyclohexane-1,2-dimethanol, cyclohexane-1,4-dimethanol, hydroxyl group-terminated butadiene-acrylonitrile copolymers, hydroxyl group-terminated spiro glycol, hydroxyl group-terminated dioxane glycol, hydroxyl group-terminated tricyclodecanedimethanol, hydroxyl group-terminated macromonomers containing polystyrene at the side chain, and hydroxyl group-terminated macromonomers containing a polystyreneacrylonitrile copolymer at the side chain. The examples also include reaction products between these diol compounds and oxides, such as ethylene oxide and propylene oxide.

The preferable reaction product as the resin (A) soluble in the aqueous alkaline solution according to the present invention is obtained by subjecting an alcoholic hydroxyl group-containing epoxy carboxylate compound produced by reaction (hereinafter referred to as a "third reaction") of an epoxy compound (d) having two epoxy groups per molecule with a monocarboxylic acid (b) having an ethylenic unsaturated group per molecule to urethane reaction (hereinafter referred to as a "fourth reaction") with a diisocyanate compound (e) and a carboxylic acid (f) having two hydroxyl groups per molecule. Here, a diol compound (g), as an optional component, may be added for reaction.

The third reaction can be carried out in the absence of a solvent or in a solvent that does not contain an alcoholic hydroxyl group. Examples the solvent include ketones, such as acetone, ethyl methyl ketone, and cyclohexanone; aromatic hydrocarbons, such as benzene, toluene, xylene, and tetramethylbenzene; glycol ethers, such as ethylene glycol dimethyl ether, ethylene glycol diethyl ether, dipropylene glycol dimethyl ether, dipropylene glycol diethyl ether, triethylene glycol dimethyl ether, and triethylene glycol diethyl ether; esters, such as ethyl acetate, butyl acetate, methyl cellosolve acetate, ethyl cellosolve acetate, butyl cellosolve acetate, carbitol acetate, propylene glycol monomethyl ether acetate, dialkyl glutarates (e.g., dimethyl glutarate), dialkyl succinates (e.g., dimethyl succinate), and dialkyl adipates (e.g., dimethyl adipate); cyclic esters, such as γ-butyrolactone; petroleum solvents, such as petroleum ether, petroleum naphtha, hydrogenated petroleum naphtha, and solvent naphtha; and the crosslinking agent (B) which will be described below. These organic solvents may be used alone or in combination of two or more.

With respect to the feed ratio of the starting materials in this reaction, preferably, the amount of the monocarboxylic acid (b) having the ethylenic unsaturated group per molecule is 80 to 120 equivalent percent relative to one equivalent of the epoxy compound (d). If the amount deviates from the range described above, there is a possibility that gelation may occur during the second reaction or the resulting resin (A) soluble in the aqueous alkaline solution may have decreased thermal stability.

During the reaction, preferably, a catalyst is used to accelerate the reaction. When the catalyst is used, the amount of use thereof is 0.1% to 10% by weight relative to the reactants. In such a case, the reaction temperature is 60°C to 150°C, and the reaction time is preferably 5 to 60 hours. Specific examples of the catalyst that may be used include triethylamine, benzyldimethylamine, triethylammonium chloride, benzyltrimethylammonium bromide, benzyltrimethylammonium iodide, triphenylphosphine, triphenylstibine, methyltriphenylstibine, chromium octanoate, and zirconium octanoate.

Furthermore, preferably, as a thermal polymerization inhibitor, hydroquinone monomethyl ether, 2-methylhydroquinone, hydroquinone, 2,6-di-tert-butyl-p-cresol, diphenylpicrylhydrazine, diphenylamine, or the like is used.

While under performing sampling in an appropriate manner, the third reaction is terminated at a point where the acid value of the sample is 1 mg·KOH/g or less, and preferably 0.5 mg·KOH/g or less.

The fourth reaction is a urethane reaction in which, after the termination of the third reaction, a carboxylic acid (f) having two hydroxyl groups per molecule and a diol compound (g) as an optional component are added to the reaction liquid, and then a diisocyanate compound (e) is gradually added thereto for reaction. The reaction can be carried out in the absence of a catalyst. Alternatively, in order to accelerate the reaction, a basic catalyst can be used. When the catalyst is used, the amount of use thereof is 10% by weight or less relative to the reactants. In such a case, the reaction temperature is 40°C to 120°C, and the reaction time is preferably 5 to 60 hours.

Furthermore, the solvent and the thermal polymerization inhibitor, such as those described above, may also be used in this case.

While performing sampling in an appropriate manner, the fourth reaction is terminated at a point where absorption at around 2,250 cm⁻¹ disappears in the infrared absorption spectrum of the sample.

With respect to the feed ratio of the carboxylic acid (f) having two hydroxyl groups per molecule, preferably, the amount of addition is calculated so that the acid value of solid content of the resin (A) soluble in the aqueous alkaline solution is 50 to 150 mg·KOH/g. If the acid value of solid content is less than 50 mg·KOH/g, solubility to the alkaline solution becomes insufficient, and there is a possibility that residue may occur when patterning is performed, or in the worst case, it may not be possible to perform patterning. If the acid value of solid content exceeds 150 mg·KOH/g, solubility to the alkaline solution becomes excessively high, and there is a possibility that the photo-cured pattern may be detached, thus being undesirable.

With respect to the feed ratio of the diisocyanate compound (e), preferably, the amount of the diisocyanate compound (e) is set so that the ratio of (the number of moles of the epoxy carboxylate compound produced by the third reaction + the number of moles of the compound (f) + the number of moles of the diol compound (g) which is optionally added) to the number of moles of the compound (e) is in the range of 1 to 5. If the ratio is less than 1, isocyanate remains at the end of the resulting resin (A) soluble in the aqueous alkaline solution. Thus, thermal stability is low, and there is a possibility that gelation may occur during storage, which is undesirable. If the ratio exceeds 5, the molecular weight of the resin (A) soluble in the aqueous alkaline solution is decreased, and problems, such as tackiness and low sensitivity, may occur.

When a solvent is used for the production of the resin (A) soluble in the aqueous alkaline solution according to the present invention, the resin (A) soluble in the aqueous alkaline solution can be isolated by removing the solvent by an appropriate method.

The amount of the resin (A) soluble in the aqueous alkaline solution used in the photosensitive resin composition of the present invention is usually 15% to 70% by weight, and preferably 20% to 60% by weight, based on 100% by weight of the solid content of the photosensitive resin composition.

As the crosslinking agent (B) used in the photosensitive resin composition of the present invention, a (meth)acrylate may be used. Specific examples thereof include 2-hydroxyethyl (meth)acrylate, 2-hydroxypropyl (meth)acrylate, 1,4-butanediol mono(meth)acrylate, carbitol (meth)acrylate, acryloyl morpholine, half esters that are reaction products of hydroxyl group-containing (meth)acrylates (e.g., 2-hydroxyethyl (meth)acrylate, 2-hydroxypropyl (meth)acrylate, and 1,4-butanediol mono(meth)acrylate) and acid anhydrides of polycarboxylic acids (e.g., succinic anhydride, maleic anhydride, phthalic anhydride, tetrahydrophthalic anhydride, and hexahydrophthalic anhydride), polyethylene glycol di(meth)acrylate, tripropylene glycol di(meth)acrylate, trimethylolpropane tri(meth)acrylate, trimethylolpropanepolyethoxy tri(meth)acrylate, glycerol polypropoxy tri(meth)acrylate, di(meth)acrylates of ε-caprolactone adduct of an ester of hydroxy pivalate and neopentyl glycol (e.g., KAYARAD HX-220 and HX-620, manufactured by Nippon Kayaku Co., Ltd.), pentaerythritol tetra(meth)acrylate, poly(meth)acrylates of a reaction product of dipentaerythritol and ε-caprolactone, dipentaerythritol poly(meth)acrylate, and epoxy (meth)acrylates that are reaction products of mono- or polyglycidyl compounds (e.g., butylglycidyl ether, phenylglycidyl ether, polyethylene glycol diglycidyl ether, polypropylene glycol diglycidyl ether, 1,6-hexanediol diglycidyl ether, hexahydrophthalic diglycidyl ester, glycerol polyglycidyl ether, glycerol polyethoxy glycidyl ether, trimethylolpropane polyglycidyl ether, and trimethylolpropane polyethoxy polyglycidyl ether) and (meth)acrylic acid.

The amount of addition thereof is usually 2% to 40% by weight, and preferably 5% to 30% by weight, based on 100% by weight of the solid content of the photosensitive resin composition.

Specific examples of the photopolymerization initiator (C) used in the photosensitive resin composition of the present invention include benzoins, such as benzoin, benzoin methyl ether, benzoin ethyl ether, benzoin isopropyl ether, and benzoin isobutyl ether; acetophenones, such as acetophenone, 2,2-diethoxy-2-phenylacetophenone, 1,1-dichloroacetophenone, 2-hydroxy-2-methyl-phenylpropan-1-one, diethoxyacetophenone, 1-hydroxycyclohexyl phenyl ketone, and 2-methyl-1-[4-(methylthio)phenyl]-2-morpholinopropan-1-one; anthraquinones, such as 2-ethylanthraquinone, 2-tert-butylanthraquinone, 2-chloroanthraquinone, and 2-amylanthraquinone; thioxanthones, such as 2,4-diethylthioxanthone, 2-isopropylthioxanthone, and 2-chlorothioxanthone; ketals, such as acetophenone dimethyl ketal and benzyl dimethyl ketal; benzophenones, such as benzophenone, 4-benzoyl-4'-methyldiphenyl sulfide, and 4,4'-bismethylaminobenzophenone; and phosphine oxides, such as 2,4,6-trimethylbenzoyl diphenylphosphine oxide, and bis(2,4,6-trimethylbenzoyl)phenylphosphine oxide. The amount of addition thereof is usually 1% to 30% by weight, and preferably 2% to 25% by weight, based on 100% by weight of the solid content of the photosensitive resin composition.

These photopolymerization initiators (C) may be used alone or in combination of two or more. Furthermore, the photopolymerization initiator (C) can be used together with an accelerator or the like. Examples of the accelerator include tertiary amines, such as triethanolamine and methyldiethanolamine; and benzoic acid derivatives, such as ethyl N,N-dimethylaminobenzoate and isoamyl N,N-dimethylaminobenzoate. The amount of addition of these accelerators is preferably 100% or less relative to the photopolymerization initiator (C).

The curing agent (D) used in the photosensitive resin composition of the present invention is an epoxy compound obtained by glycidylating a compound containing not less than 80% of a tetraphenylethane derivative represented by the formula (1) described above [wherein R₁ to R₈ each independently represents a hydrogen atom, a C₁ to C₄ alkyl group, or a halogen atom]. In a resin coating film obtained by applying the photosensitive resin composition, followed by photo-curing, the remaining carboxyl group and the epoxy group of the epoxy compound are reacted by heating, and thus a high-performance cured coating film having strong chemical resistance and the like by means of the curing agent (D) can be obtained.

Specific examples of the C₁ to C₄ alkyl group in R₁ to R₈ in the formula (1) include a methyl group, an ethyl group, an n-propyl group, an isopropyl group, an n-butyl group, an s-butyl group, and a tert-butyl group.

Examples of the halogen atom in R₁ to R₈ in the formula (1) include a fluorine atom, a chlorine atom, a bromine atom, and an iodine atom.

The epoxy compound can be synthesized by a known method. That is, the epoxy compound can be obtained by glycidylating a tetraphenylethane derivative obtained by condensation of glyoxal with phenols.

Specific examples of phenols that is allowed to condense with glyoxal include unsubstituted phenols, such as phenol, resorcinol, and hydroquinone; substituted phenols, such as o-cresol, m-cresol, p-cresol, ethylphenol, n-propylphenol, isopropylphenol, tert-butylphenol, octylphenol, nonylphenol, phenylphenol, cyclohexylphenol, xylenol, methylpropylphenol, methylbutylphenol, allylphenol, and aminophenol; and halogen atom-containing substituted phenols, such as brominated phenol. These phenols may be used alone or in combination of two or more. When these phenols have positional isomers, all such isomers can be used in the present invention. As phenols, phenol, o-cresol, m-cresol, and p-cresol are preferable, and phenol is particularly preferable.

As the tetraphenylethane derivative for producing the epoxy compound, which is the curing agent (D), contained in the photosensitive resin composition of the present invention, a compound in which each R₁ to R₈ is a hydrogen atom is preferable. As the commercially available tetraphenylethane derivative, TEP-DF (manufactured by Asahi Organic Chemicals Industry Co., Ltd.) is desirable.

Glycidylation of the tetraphenylethane derivative will now be described below.

After or while adding an alkali metal hydroxide to a mixture of the tetraphenylethane derivative and an excess amount of epihalohydrin, reaction is allowed to take place at 20°C to 120°C. The alkali metal hydroxide may be used as an aqueous solution thereof. In such a case, a method may be employed in which the aqueous solution of the alkali metal hydroxide is continuously added to the reaction mixture, water and epihalohydrin are continuously distilled under reduced pressure or under normal pressure, the distillate is separated to remove water, and epihalohydrin is continuously returned to the reaction system.

Alternatively, a method may be employed in which an etherified halohydrin compound is prepared by adding a quaternary ammonium salt, such as tetramethylammonium chloride, tetramethylammonium bromide, or trimethylbenzylammonium chloride, to the tetraphenylethane derivative and epihalohydrin, and allowing reaction to take place at 50°C to 150°C; then, a solid or an aqueous solution of an alkali metal hydroxide is added to the etherified halohydrin compound, and reaction is allowed to take place at 20°C to 120°C to cause dehydrohalogenation (ring closure).

In general, the amount of epihalohydrin used in such a reaction is usually 1 to 20 moles, and preferably 1.5 to 10 moles, relative to one equivalent of the phenolic hydroxyl group of the tetraphenylethane derivative. The amount of use of the alkali metal hydroxide is 0.8 to 1.5 moles, and preferably 0.9 to 1.1 moles, relative to one equivalent of the phenolic hydroxyl group of the tetraphenylethane derivative. Furthermore, in order to allow the reaction to proceed smoothly, preferably, an alcohol, such as methanol or ethanol, and an aprotic polar solvent, such as dimethyl sulfone or dimethyl sulfoxide, is added to the reaction mixture.

When an alcohol is added, the amount of use thereof is preferably 2% to 40% by weight, and particularly preferably 4% to 30% by weight, relative to the amount of use of epihalohydrin. When an aprotic polar solvent is added, the amount of use thereof is preferably 5% to 100% by weight, and particularly preferably 10% to 90% by weight, relative to the amount of use of epihalohydrin.

After washing the reaction mixture of these glycidylation reactions with water, or without water washing, epihalohydrin, the solvent, and the like are removed under heating and reduced pressure. Thus, an epoxy compound can be obtained. Furthermore, by using a crystallization method in which the epoxy compound is dissolved under heating in a solvent, such as methyl isobutyl ketone, followed by cooling, it is possible to obtain the epoxy compound as crystals.

As necessary, the following treatment may be performed. The resulting epoxy resin is dissolved in a hydrophobic solvent, an alkali metal hydroxide in an amount of 0.025 to 0.3 moles relative to one mole of the phenolic hydroxyl group of the tetraphenylethane derivative used as the starting material is added to the solution, and stirring is performed preferably at 40°C to 90°C for 30 minutes to 3 hours to perform dehalogenation. In such a case, preferably, a 5 to 50 weight percent aqueous solution of the alkali metal hydroxide is used. Specific examples of the hydrophobic solvent include methyl isobutyl ketone, benzene, toluene, and xylene. Methyl isobutyl ketone and toluene are preferable. These solvents may be used alone or in combination. After the reaction is completed, the resulting solution is washed with water several times, and the hydrophobic solvent is distilled off under reduced pressure. Thus, a desired epoxy compound can be obtained. Furthermore, the epoxy compound can be obtained as crystals by the same crystallization method as that described above.

The epoxy compound, which is the curing agent (D), may include a compound represented by the formula (2) [wherein R₁ to R₈ each independently represents a hydrogen atom, a C₁ to C₄ alkyl group, or a halogen atom], and the content of the compound in the curing agent (D) is preferably not less than 60 mole percent, and more preferably not less than 80 mole percent.

The C₁ to C₄ alkyl group or the halogen atom is the same as that described with reference to the formula (1).

Other components contained in the curing agent (D) are compounds produced as by-products during the reaction between epihalohydrin and the tetraphenylethane derivative, and like, which are mainly phenolic hydroxyl group adducts of the epoxy group.

Furthermore, the epoxy compound, which is the curing agent (D), may be a compound obtained by glycidylating a compound containing not less than 80% of a tetraphenylethane derivative wherein R₁ to R₈ are each a hydrogen atom, and the epoxy equivalent thereof is preferably in the range of 120 to 200 g/equivalent, and particularly preferably in the range of 155 to 180 g/equivalent.

The amount of addition of the curing agent (D) contained in the photosensitive resin composition of the present invention is preferably 200% or less of the equivalent calculated from the acid value of solid content and the amount of use of the resin (A) soluble in the aqueous alkaline solution contained in the photosensitive resin composition. If the amount exceeds 200%, there is a possibility that developability may be significantly degraded, which is undesirable.

Furthermore, preferably, the curing agent (D) contained in the photosensitive resin composition of the present invention has a softening point or melting point of not less than 80°C. In particular, the curing agent (D) preferably has a melting point of not less than 100°C, and more preferably not less than 150°C.

Furthermore, the curing agent (D) contained in the photosensitive resin composition of the present invention preferably has a light transmittance at 400 nm of not less than 10%, and particularly preferably not less than 30%, in a 1 weight percent methyl ethyl ketone solution. Examples of the commercially available epoxy resin include YDG 414 (manufactured by Tohto Kasei Co., Ltd.) and EPIKOTE 1031S (manufactured by Japan Epoxy Resin Co., Ltd.), each of which has a very high absorbance at 400 nm or less (i.e., a light transmittance of 0.0% in a 0.1 weight percent methyl ethyl ketone solution). In the case where these epoxy resins are used for the photosensitive resin composition, since the absorption maximum wavelength of the photopolymerization initiator (C) is usually 400 nm or less, the properties, such as developability, of cured products of the photosensitive resin composition are extremely poor.

The photosensitive resin composition of the present invention may be further incorporated with various types of additives as required in order to improve properties of the composition. Examples of such additives include fillers, such as talc, barium sulfate, calcium carbonate, magnesium carbonate, barium titanate, aluminum hydroxide, aluminum oxide, silica, and clay; thixotropy imparting agents, such as Aerosil; coloring agents, such as phthalocyanine blue, phthalocyanine green, and titanium oxide; silicone- or fluorine-based leveling agents and antifoaming agents; and polymerization inhibitors, such as hydroquinone and hydroquinone monomethyl ether.

Although the curing agent (D) to be contained in the photosensitive resin composition of the present invention may be mixed in advance in the resin composition when used as a liquid resist, the curing agent (D) may be mixed before application to printed wiring boards. That is, preferably, a two-part system is formed in which a base solution including the resin (A) soluble in the aqueous alkaline solution as the main component, and an epoxy-curing accelerator and the like added thereto, and a curing agent solution including the curing agent (D) as the main component are separately prepared, and these solutions are mixed immediately before use.

The photosensitive resin composition of the present invention contains a resin (A) soluble in an aqueous alkaline solution, a crosslinking agent (B), a photopolymerization initiator (C), and a curing agent (D).

The photosensitive resin composition of the present invention can be formed into a photosensitive layer, as necessary, by adding a filler, additives, and the like, and by sandwiching the photosensitive layer between a support film and a protective film, a dry film resist can be produced. In such a case, the protective film is peeled off when used. After lamination on a substrate, exposure is performed, the supporting film is peeled off, and development is performed.

The photosensitive resin composition of the present invention is useful as interlayer insulating materials for electronic components, optical waveguides that connect between optical components, solder resists for printed wiring boards, and resist materials, such as cover lays. In addition, the photosensitive resin composition can also be used for color filters, printing ink, sealing materials, paint, coating materials, adhesives, and the like.

A cured product of the photosensitive resin composition of the present invention is also covered by the present invention. The photosensitive resin composition of the present invention is cured by irradiation of an energy ray, such as ultraviolet light. The curing by irradiation of an energy ray, such as ultraviolet light can be performed by an ordinary method. For example, when ultraviolet light is used, an ultraviolet generator, such as a low-pressure mercury lamp, a high-pressure mercury lamp, an ultrahigh-pressure mercury lamp, a xenon lamp, or an ultraviolet-light-emitting laser (e.g., an excimer laser), may be used.

The cured product of the resin composition of the present invention is used for electrical, electronic, and optical substrates, for example, as resist films, interlayer insulating materials used in a build-up process, and optical waveguides in printed wiring boards, photoelectronic substrates, and optical substrates, and these substrates are also covered by the present invention. The thickness of the layer of the cured product is about 0.5 to 160 µm, and preferably about 1 to 100 µm.

Articles including these substrates are also covered by the present invention, and specific examples thereof include computers, home electric appliances, and mobile devices.

A printed wiring board including the photosensitive resin composition of the present invention can be obtained, for example, by the following method. That is, when a liquid resin composition is used, the composition of the present invention is applied onto a substrate for a printed wiring board by a process, such as screen-printing, spraying, roll-coating, electrostatic coating, or curtain-coating, at a thickness of 5 to 160 µm, and drying is performed usually at 50°C to 110°C, and preferably at 60°C to 100°C. A coating film is thereby formed. Subsequently, a high-energy ray, such as ultraviolet light, is applied usually at an intensity of about 10 to 2,000 mJ/cm² directly or indirectly to the coating film through a photomask provided with an exposure pattern, such as a negative film. The unexposed portions are developed with a developer, which will be described below, for example, by means of spraying, dipping under shaking, brushing, and scrubbing. Subsequently, as necessary, ultraviolet light is irradiated, and then heat treatment is performed usually at 100°C to 200°C, and preferably at 140°C to 180°C. Thus, a printed wiring board provided with a permanent protective film that satisfies various properties, such as heat resistance, solvent resistance, acid resistance, and adhesiveness, is obtained.

Examples of an aqueous alkaline solution used for the development described above include aqueous inorganic alkaline solutions, such as potassium hydroxide, sodium hydroxide, sodium carbonate, potassium carbonate, sodium bicarbonate, potassium bicarbonate, sodium phosphate, and potassium phosphate; and aqueous organic alkaline solutions, such as tetramethylammonium hydroxide, tetraethylammonium hydroxide, tetrabutylammonium hydroxide, monoethanolamine, diethanolamine, and triethanolamine.

The resin (A) soluble in the aqueous alkaline solution according to the present invention is soluble in an aqueous alkaline solution and is also soluble in the solvent described above. When used in solder resists, plating resists, and the like, it is possible to perform development using the solvent.

### EXAMPLES

While the present invention will be described in more detail based on examples below, it is to be understood that the present invention is not limited to the examples.

### Synthesis Example 1

A 3-L flask equipped with an agitator and a reflux tube was charged with 860.0 g of EOCN-103S manufactured by Nippon Kayaku Co., Ltd. (polyfunctional cresol novolak epoxy resin; epoxy equivalent: 215.0 g/equivalent) as an epoxy compound (a) having two or more epoxy groups per molecule, 288.3 g of acrylic acid (molecular weight: 72.06) as a monocarboxylic acid (b) having an ethylenic unsaturated group per molecule, 492.1 g of carbitol acetate as a reaction solvent, 4.921 g of 2,6-di-tert-butyl-p-cresol as a thermal polymerization inhibitor, and 4.921 g of triphenylphosphine as a reaction catalyst, and reaction was allowed to take place at 98°C until the reaction liquid had an acid value of 0.5 mg·KOH/g or less. Thereby, an epoxy carboxylate compound was obtained.

Subsequently, 169.8 g of carbitol acetate as a reaction solvent and 201.6 g of tetrahydrophthalic anhydride as a polybasic acid anhydride (c) were added to the reaction liquid, and reaction was allowed to take place at 95°C for 4 hours to obtain a resin solution (hereinafter referred to as "A-1") containing 67% by weight of a resin (A) soluble in an aqueous alkaline solution. The acid value was measured to be 69.4 mg·KOH/g (acid value of solid content: 103.6 mg·KOH/g).

### Synthesis Example 2

A 3-L flask equipped with an agitator and a reflux tube was charged with 368.0 g of RE-310S manufactured by Nippon Kayaku Co., Ltd. (bifunctional bisphenol-A epoxy resin; epoxy equivalent: 184.0 g/equivalent) as an epoxy compound (d) having two or more epoxy groups per molecule, 141.2 g of acrylic acid (molecular weight: 72.06) as a monocarboxylic acid (b) having an ethylenic unsaturated group per molecule, 1.02 g of hydroquinone monomethyl ether as a thermal polymerization inhibitor, and 1.53 g of triphenylphosphine as a reaction catalyst, and reaction was allowed to take place at 98°C until the reaction liquid had an acid value of 0.5 mg·KOH/g or less. Thereby, an epoxy carboxylate compound (theoretical molecular weight: 509.2) was obtained.

Subsequently, 755.5 g of carbitol acetate as a reaction solvent, 268.3 g of 2,2-bis(dimethylol)propionic acid (molecular weight: 134.16) as a carboxylic acid (f) having two hydroxyl groups per molecule, 1.08 g of 2-methylhydroquinone as a thermal polymerization inhibitor, and 140.3 g of spiroglycol (molecular weight: 304.38) as a diol compound (g) as the optional component were added to the reaction liquid, and the temperature was increased to 45°C. Then, 485.2 g of trimethylhexamethylene diisocyanate (molecular weight: 210.27) as a diisocyanate compound (e) was gradually added dropwise to the solution such that the reaction temperature did not exceed 65°C. After the dropwise addition was completed, the temperature was increased to 80°C, and reaction was allowed to take place for 6 hours until absorption at around 2,250 cm⁻¹ disappeared in infrared absorption spectrum analysis. Thereby, a resin solution (hereinafter referred to as "A-2") containing 65% by weight of a resin (A) soluble in an aqueous alkaline solution according to the present invention was obtained. The acid value was measured to be 52.0 mg·KOH/g (acid value of solid content: 80.0 mg·KOH/g).

### Synthesis Example 3

Under nitrogen gas purge, 149 g of TEP-DF (manufactured by Asahi Organic Chemicals Industry Co., Ltd., 1,1,2,2-tetrakis(4-hydroxyphenyl)ethane content: 99%; measured at UV 254 nm by high performance liquid chromatography (HPLC)), 555 g of epichlorohydrin, and 111 g of methanol were placed in a flask equipped with a thermometer, a cooling tube, and an agitator, and dissolution was performed. The solution was heated to 70°C, 60 g of sodium hydroxide flake was added in portions thereto over 100 minutes, and then reaction was allowed to take place at 70°C for 75 minutes. After the reaction was completed, excess epichlorohydrin and methanol were distilled off under reduced pressure of 5 mmHg at 130°C using a rotary evaporator, and the residue was dissolved in 470 g of methyl isobutyl ketone.

The methyl isobutyl ketone solution was heated to 70°C, and 23 g of methanol and 10 g of a 30 weight percent aqueous sodium hydroxide solution were added thereto. After reaction was allowed to take place for 1 hour, water washing was repeated until the pH of the wash liquid became neutral. The aqueous layer was separated, and methyl isobutyl ketone was removed by distillation from the organic layer using a rotary evaporator. Thereby, 219 g of an epoxy compound (D-1) in which the molar ratio of 1,1,2,2-tetrakis(4-glycidyloxyphenyl)ethane was 74% (measured by HPLC) was obtained. The epoxy equivalent was 170 g/equivalent. The melt viscosity at 150°C (measured by the cone-and-plate method at 150°C; measuring apparatus: Cone & Plate (ICI) high-temperature viscometer (manufactured by RESEARCH EQUIPMENT (LONDON) LTD.), cone No.: 3 (measurement range 0 to 2.00 Pa·s), amount of sample: 0.155±0.01 g) was 0.4 poise. The softening point (measured according to JIS K-7234) was 81.4°C.

### Synthesis Example 4

Under nitrogen gas purge, 300 g of TEP-DF (manufactured by Asahi Organic Chemicals Industry Co., Ltd., 1,1,2,2-tetrakis(4-hydroxyphenyl)ethane content: 99%; measured at UV 254 nm by HPLC), 1,110 g of epichlorohydrin, and 240 g of methanol were placed in a flask equipped with a thermometer, a cooling tube, and an agitator, and dissolution was performed. The solution was heated to 70°C, 120 g of sodium hydroxide flake was added in portions thereto over 100 minutes, and then reaction was allowed to take place at 70°C for 60 minutes. After the reaction was completed, washing was performed twice with 450 parts of water, and excess epichlorohydrin and the like were distilled off from the resulting organic layer under heating and reduced pressure. The residue was dissolved in 1,500 g of methyl isobutyl ketone under reflux conditions, and the solution was gradually cooled to 4°C and left to stand for 24 hours. The resulting crystals were subjected to filtration and drying, and thereby 294 g of a target epoxy compound (D-2) (epoxy equivalent: 165 g/equivalent, melting point: 174°C, 1,1,2,2-tetrakis(glycidyloxyphenyl)ethane content: 87 percent by area; measured by HPLC at UV 254 nm, light transmittance at 400 nm in a 1 weight percent methyl ethyl ketone solution: ≥99%) was obtained as colorless crystals.

### Examples 1, 2, and 3

Using the curing agent (D-1) obtained in Synthesis Example 3 or the curing agent (D-2) obtained in Synthesis Example 4, the resin solution (A-1) obtained in Synthesis Example 1 or the resin solution (A-2) obtained in Synthesis Example 2 and other components were mixed at the mixing ratios shown in Table 1, and as necessary, kneaded with a three-roll mill. Thus, photosensitive resin compositions of the present invention were obtained. Each of these resin compositions was applied onto a printed board by screen-printing such that the dry thickness was 15 to 25 µm, and the coating film was dried at 80°C with a hot-air dryer for 30 minutes. Subsequently, irradiation of ultraviolet light was performed, through a mask on which a circuit pattern had been drawn, with a UV exposure unit (manufactured by ORC Manufacturing Co., Ltd., Model HMW-680GW). Then, spray development was performed using a 1 weight percent aqueous sodium carbonate solution to remove the resin at the portions not irradiated with ultraviolet light. Water washing and drying were performed, and then the printed board was subjected to thermal curing reaction at 150°C for 60 minutes with a hot-air dryer. A cured film was thus obtained. The coating film was tested with respect to tackiness, developability by performing development, and resolution, and the resulting cured product was tested with respect to photosensitivity, surface gloss, adhesiveness, pencil hardness, solvent resistance, acid resistance, heat resistance, gold plating resistance, PCT resistance, and thermal shock resistance. The results thereof are shown in Table 2. The test methods and the evaluation methods are as follows.

(Tackiness) The coating film applied to the board after drying was rubbed with absorbent cotton, and tackiness of the coating film was evaluated.
○ .... Absorbent cotton did not stick.
× .... Absorbent cotton waste stuck to the film.

(Developability) The following evaluation criteria were used.
○ .... During development, ink was completely removed and development was performed completely.
× .... During development, undeveloped portions occurred.

(Resolution) A negative pattern of 50 µm was brought into close contact with the coating film after drying, and irradiation exposure was performed with ultraviolet light in an integrated amount of 200 mJ/cm². Subsequently, development was performed with a 1 weight percent aqueous sodium carbonate solution for 60 seconds at a spray pressure of 2.0 kg/cm². The transferred pattern was observed with a microscope. The following criteria were used.
○ .... Resolved pattern had linear pattern edge.
× .... Detachment occurred or pattern edge was irregular.

(Photosensitivity) A 21 step tablet (manufactured by Kodak Corp.) was brought into close contact with the coating film after drying, and irradiation exposure was performed with ultraviolet light in an integrated amount of 500 mJ/cm². Subsequently, development was performed with a 1 weight percent aqueous sodium carbonate solution for 60 seconds at a spray pressure of 2.0 kg/cm². The number of steps remaining without being developed was confirmed.

(Surface gloss) Irradiation exposure was performed with ultraviolet light in an amount of 500 mJ/cm². Subsequently, development was performed with a 1 weight percent aqueous sodium carbonate solution for 60 seconds at a spray pressure of 2.0 kg/cm², and the cured film after drying was observed. The following criteria were used.
○ .... No haze was observed.
× .... Slight haze was observed.

(Adhesiveness) According to JIS K5400, 100 squares (1 mm) were made on a test piece, and a peeling test was performed using a cellophane adhesive tape. The peeling state of the squares was observed, and evaluation was performed with the following criteria.
O .... No peeling occurred.
x .... Peeling occurred.

(Pencil hardness) Evaluation was performed according to JIS K5400.

(Solvent resistance) A test piece was dipped in isopropyl alcohol at room temperature for 30 minutes. After checking whether or not abnormality occurred on the appearance, a peeling test was performed using a cellophane adhesive tape, and evaluation was performed with the following criteria.

○ .... No abnormality was observed on the appearance of the coating film, and no blister or peeling was observed.

× .... Blister and peeling were observed in the coating film.

(Acid resistance) A test piece was dipped in a 10% aqueous hydrochloric acid solution at room temperature for 30 minutes. After checking whether or not abnormality occurred on the appearance, a peeling test was performed using a cellophane adhesive tape, and evaluation was performed with the following criteria.
○ .... No abnormality was observed on the appearance of the coating film, and no blister or peeling was observed.
× .... Blister and peeling were observed in the coating film.

(Heat resistance) A rosin-based plux was applied to a test piece, and the test piece was dipped in a solder bath at 260°C for 5 seconds. This step was considered as one cycle, and three cycles were repeated. After the test piece was allowed to be cooled to room temperature, a peeling test was performed using a cellophane adhesive tape, and evaluation was performed with the following criteria.
○ .... No abnormality was observed on the appearance of the coating film, and no blister or peeling was observed.
× .... Blister and peeling were observed in the coating film.

(Gold plating resistance) A test substrate was dipped in an acidic degreasing solution (20 volume percent aqueous solution of Metex L-5B manufactured by Nippon MacDermid Co., Ltd.) at 30°C for 3 minutes, followed by washing with water. Subsequently, the test substrate was dipped in a 14.4 weight percent aqueous ammonium persulfate solution for 3 minutes, followed by washing with water. Furthermore, the test substrate was dipped in a 10 volume percent aqueous sulfuric acid solution at room temperature for one minute, followed by washing with water. Subsequently, the substrate was dipped in a catalyst solution (10 volume percent aqueous solution of Metal Plate Activator 350 manufactured by Meltex Inc.) at 30°C for 7 minutes, followed by washing with water, and then the substrate was subjected to nickel plating by dipping in a nickel plating solution (20 volume percent aqueous solution of Melplate Ni-865M, manufactured by Meltex Inc., pH 4.6) at 85°C for 20 minutes. Then, the test substrate was dipped in a 10 volume percent aqueous sulfuric acid solution at room temperature for one minute, and washing with water was performed. Subsequently, the test substrate was subjected to electroless gold plating by dipping in a gold plating solution (an aqueous solution of 15 volume percent of Aurolectroless UP manufactured by Meltex Inc. and 3 volume percent of gold potassium cyanide, pH 6) at 95°C for 10 minutes, followed by washing with water. Furthermore, the test substrate was dipped in hot water at 60°C for 3 minutes, followed by washing with water and drying. A cellophane adhesive tape was applied to the resulting electroless gold plated substrate for evaluation, and the state when the adhesive tape was peeled off was observed.
○ .... No abnormality was observed
× .... Peeling was slightly observed.

(PCT resistance) A test substrate was left to stand in water at 121°C and 2 atm for 96 hours. After checking whether or not abnormality occurred on the appearance, a peeling test was performed using a cellophane adhesive tape, and evaluation was performed with the following criteria.
○ No abnormality was observed on the appearance of the coating film, and no blister or peeling was observed.
× Blister and peeling were observed in the coating film.

(Thermal shock resistance) A test piece was subjected to thermal hysteresis of 1,000 cycles, one cycle including -55°C/30 minutes and 125°C/30 minutes. Then, the test piece was observed with a microscope, and evaluation was performed with the following criteria.
○ No cracks occurred in the coating film
× Cracks occurred in the coating film.

### Comparative Examples 1 and 2

Photosensitive resin compositions for comparison were obtained by using TEPIC manufactured by Nissan Chemical Industries, Ltd (Comparative Example 1) or EPIKOTE 1031S manufactured by Japan Epoxy Resin Co., Ltd. (Comparative Example 2) instead of the curing agent used in Examples 1, 2, and 3, and mixing at the mixing ratios shown in Table 1'. Cured films were obtained therefrom as in Examples. Tests were carried out as in Examples, and the results thereof are shown in Table 2.

**TABLE 1**

| | Remarks | Example | | |
|---|---|---|---|---|
| | | 1 | 2 | 3 |
| Resin solution | | | | |
| A-1 | | 51.80 | | 51.80 |
| A-2 | | | 51.80 | |
| Crosslinking agent (B) | | | | |
| DPHA | *1 | 3.38 | | 3.38 |
| HX-220 | *2 | | 3.38 | |
| Photopolymerization initiator (C) | | | | |
| Irgacure-907 | *3 | 4.50 | 4.50 | 4.50 |
| DETX-S | *4 | 0.45 | 0.45 | 0.45 |
| Curing agent (D) | | | | |
| D-1 | | 17.62 | 17.62 | |
| D-2 | | | | 17.62 |
| Thermal curing catalyst | | | | |
| Melamine | | 1.00 | 1.00 | 1.00 |
| Filler | | | | |
| Barium sulfate | | 15.15 | 15.15 | 15.15 |
| Phthalocyanine blue | | 0.45 | 0.45 | 0.45 |
| Additive | | | | |
| BYK-354 | *7 | 0.39 | 0.39 | 0.39 |
| KS-66 | *8 | 0.39 | 0.39 | 0.39 |
| Solvent | | | | |
| CA | *9 | 4.87 | 4.87 | 4.87 |

**TABLE 1'**

| | Remarks | Comparative Example | |
|---|---|---|---|
| | | 1 | 2 |
| Resin solution | | | |
| A-1 | | 51.80 | 51.80 |
| Crosslinking agent (B) | | | |
| DPHA | *1 | 3.38 | 3.38 |
| Photopolymerization initiator (C) | | | |
| Irgacure-907 | *3 | 4.50 | 4.50 |
| DETX-S | *4 | 0.45 | 0.45 |
| Curing agent (D) | | | |
| TEPIC | *5 | 17.62 | |
| EPIKOTE1031S | | | 17.62 |
| Thermal curing catalyst | | | |
| Melamine | | 1.00 | 1.00 |
| Filler | | | |
| Barium sulfate | | 15.15 | 15.15 |
| Phthalocyanine blue | | 0.45 | 0.45 |
| Additive | | | |
| BYK-354 | *7 | 0.39 | 0.39 |
| KS-66 | *8 | 0.39 | 0.39 |
| Solvent | | | |
| CA | *9 | 4.87 | 4.87 |

| | | | |
|---|---|---|---|
| Remarks 1 manufactured by Nippon Kayaku Co., Ltd.: dipentaerythritol polyacrylate 2 manufactured by Nippon Kayaku Co., Ltd.: ε-caprolactone-modified hydroxypivalic acid ester neopentyl glycol diacrylate 3 manufactured by Vantico Corp.: 2-methyl-1-[4-(methylthio)phenyl]-2-morpholinopropan-1-one 4 manufactured by Nippon Kayaku Co., Ltd.: 2,4-diethylthioxanthone 5 manufactured by Nissan Chemical Industries, Ltd.: triglycidyl isocyanurate 6 manufactured by Japan Epoxy Resin Co., Ltd.: EPIKOTE 1031S 7 manufactured by BYK-Chemie: leveling agent 8 manufactured by Shin-etsu Chemical Ind.: antifoaming agent 9 carbitol acetate | | | |

**TABLE 2**

| Evaluation item | Example | | | Comparative Example | |
|---|---|---|---|---|---|
| | 1 | 2 | 3 | 1 | 2 |
| Tackiness | ○ | ○ | ○ | ○ | × |
| Developability | ○ | ○ | ○ | ○ | × |
| Resolution | ○ | ○ | ○ | ○ | × |
| Photosensitivity | 12 | 8 | 12 | 11 | 5 |
| Surface gloss | ○ | ○ | ○ | ○ | ○ |
| Adhesiveness | ○ | ○ | ○ | ○ | × |
| Pencil hardness | 8H | 4H | 8H | 7H | 6H |
| Solvent resistance | ○ | ○ | ○ | × | × |
| Acid resistance | ○ | ○ | ○ | × | ○ |
| Heat resistance | ○ | ○ | ○ | ○ | ○ |
| Gold plating resistance | ○ | ○ | ○ | ○ | ○ |
| PCT resistance | ○ | ○ | ○ | × | ○ |
| Thermal shock resistance | ○ | ○ | ○ | × | ○ |

As is evident from the results shown above, the photosensitive resin composition of the present invention containing, as a curing agent, an epoxy compound obtained by glycidylating a compound represented by formula (1) and the cured product thereof are excellent particularly in solvent resistance, acid resistance, and PCT resistance. Furthermore, cracks do not occur in the surface of the cured product, and the photosensitive resin composition of the present invention is particularly useful as photosensitive resin composition for printed boards. On the other hand, in Comparative Example 2 in which EPIKOTE 1013S, which is a commercially available epoxy compound, is used as a curing agent, tackiness, developability, resolution, and adhesiveness are inferior compared to the photosensitive resin composition of the present invention and the cured product thereof.

### Example 3: Preparation of dry film

A resist resin composition was obtained by mixing 54.44 g of a resin which was prepared as in Synthesis Example 2 except that the solvent in the solution (A-2) of the resin soluble in the aqueous alkaline solution was changed to propylene glycol monomethyl ether, 3.54 g of HX-220 (trade name: diacrylate monomer manufactured by Nippon Kayaku Co., Ltd.) as a crosslinking agent (B), 4.72 g of Irgacure-907 (manufactured by Ciba Specialty Chemicals) and 0.47 g of Kayacure-DETX-S (manufactured by Nippon Kayaku Co., Ltd.) as photopolymerization initiators (C), 14.83 g of the compound (D-2) obtained in Synthesis Example 4 as a curing component, 1.05 g of melamine as a thermal curing catalyst, and 20.95 g of methyl ethyl ketone as a concentration-regulating solvent, and kneading the mixture with a bead mill to achieve uniform dispersion.

The resulting composition was applied uniformly onto a poly(ethylene terephthalate) film, i.e., a support film, by a roll-coating process, the film was transported through a hot-air drying furnace at 70°C, to form a resin layer with a thickness of 30 µm. Then, a polyethylene film, i.e., a protective film, was attached to the resin layer to prepare a dry film. The resin layer of the resulting dry film was attached to the entire surface of a polyimide printed board (thickness of copper circuit: 12 µm, thickness of polyimide film: 25 µm) using a hot roller at 80°C while peeling off the protective film. Subsequently, using a UV exposure unit (manufactured by ORC Manufacturing Co., Ltd., Model HMW-680GW), irradiation of ultraviolet light was performed, through a mask on which a circuit pattern had been drawn. Then, spray development was performed using a 1 weight percent aqueous sodium carbonate solution to remove the resin at the portions not irradiated with ultraviolet light. After washing with water, the printed board was subjected to thermal curing reaction with a hot-air dryer at 150°C for 60 minutes to produce a cured film. With respect to the cured product, as in the tests described above, photosensitivity, surface gloss, adhesiveness, pencil hardness, solvent resistance, acid resistance, heat resistance, and gold plating resistance were tested. Substantially the same results as those shown in Example 2 of Table 2 were obtained.

As is evident from the results, the photosensitive resin composition of the present invention containing, as a curing agent, a compound represented by formula (1) and the cured product thereof do not exhibit tackiness and have excellent developability even if used as a dry film. The cured film thereof is also excellent in resistance to soldering heat, chemical resistance, gold plating resistance, and the like. Furthermore, cracks do not occur in the surface of the cured product, and the photosensitive resin composition of the present invention is excellent as a photosensitive resin composition for printed boards.

## Claims

1. A photosensitive resin composition containing a resin (A) soluble in an aqueous alkaline solution, a crosslinking agent (B), a photopolymerization initiator (C), and a curing agent (D), wherein the curing agent (D) is an epoxy compound obtained by glycidylating a compound containing not less than 80% of a tetraphenylethane derivative represented by formula (1) : 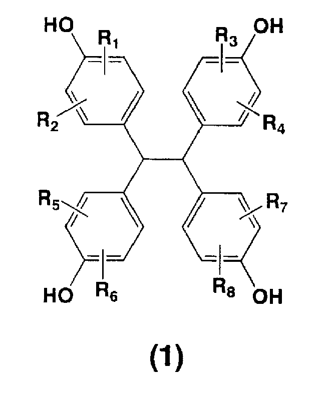 [wherein R₁ to R₈ each independently represents a hydrogen atom, a C₁ to C₄ alkyl group, or a halogen atom].

2. The photosensitive resin composition according to Claim 1, wherein the epoxy compound, which is the curing agent (D), is a compound obtained by glycidylating a tetraphenylethane derivative represented by formula (1) wherein each R₁ to R₈ is a hydrogen atom, and the compound has an epoxy equivalent of 120 to 200 g/equivalent.

3. The photosensitive resin composition according to Claim 1, wherein the epoxy compound, which is the curing agent (D), includes a compound represented by formula (2): 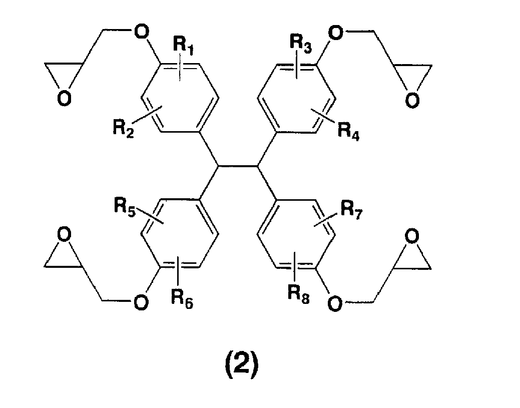 [wherein R₁ to R₈ each independently represents a hydrogen atom, a C₁ to C₄ alkyl group, or a halogen atom] and the content of the compound in the curing agent (D) is not less than 60 mole percent.

4. The photosensitive resin composition according to any one of Claims 1 to 3, wherein the curing agent (D) has a softening point or melting point of not less than 80°C.

5. The photosensitive resin composition according to any one of Claims 1 to 3, wherein the curing agent (D) has a light transmittance at 400 nm of not less than 10% in a 1 weight percent methyl ethyl ketone solution.

6. The photosensitive resin composition according to any one of Claims 1 to 5, wherein the resin (A) soluble in the aqueous alkaline solution is a reaction product between an epoxy carboxylate compound obtained by reaction of an epoxy compound (a) having two or more epoxy groups per molecule with a monocarboxylic acid (b) having an ethylenic unsaturated group per molecule, and a polybasic acid anhydride (c).

7. The photosensitive resin composition according to any one of Claims 1 to 5, wherein the resin (A) soluble in the aqueous alkaline solution is a reaction product between an epoxy carboxylate compound obtained by reaction of an epoxy compound (d) having two epoxy groups per molecule with a monocarboxylic acid (b) having an ethylenic unsaturated group per molecule, a diisocyanate compound (e), a carboxylic acid (f) having two hydroxyl groups per molecule, and, as an optional component, a diol compound (g).

8. A cured product of the photosensitive resin composition according to any one of Claims 1 to 7.

9. A substrate comprising a layer composed of the cured product according to Claim 8.

10. An article comprising the substrate according to Claim 9.
